Europäisches Patentamt

European Patent Office

Office européen des brevets

(11) Publication number: **0 219 430**
A2

# (12) EUROPEAN PATENT APPLICATION

(21) Application number: 86402220.7

(22) Date of filing: 07.10.86

(51) Int. Cl.⁴: **H 01 L 29/94**

(30) Priority: 07.10.85 US 785197

(43) Date of publication of application:
22.04.87 Bulletin 87/17

(84) Designated Contracting States:
AT DE FR GB IT NL

(71) Applicant: THOMSON COMPONENTS-MOSTEK
CORPORATION
1310 Electronics Drive
Carrollton Texas 75006(US)

(72) Inventor: Chan, Tsiu C.
THOMSON-CSF SCPI 19, avenue de Messine
F-75008 Paris(FR)

(72) Inventor: Han, Yu-Pin
THOMSON-CSF SCPI 19, avenue de Messine
F-75008 Paris(FR)

(74) Representative: Ruellan-Lemonnier, Brigitte et al,
THOMSON-CSF SCPI 19, avenue de Messine
F-75008 Paris(FR)

(54) Self-healing MOS capacitor.

(57) An improved parallel-plate capacitor for integrated circuits incorporate one plate formed from P-type silicon and the other plate formed from N-type silicon, with the voltage applied to the plate bing restricted by the condition that the N-type plate have voltage the same as or more positive than the P-type plate, so that a pinhole short circuit will produce a reverse-biased diode in the N-type plate that will not short out the capacitor.

*FIG. 2*

## Self-Healing MOS Capacitor

Technical Field

The field of the invention is that of the fabrication of capacitors in integrated circuits using MOS technology.


Background Art

A well known fabrication technique for capacitors in the prior art employs a parallel plate capacitor in which one plate is a doped region of the substrate and the other plate is a layer of polycrystalline silicon doped with a material having the same polarity as the lower doped region. Conventionally, the channel and the polycrystalline silicon have the same polarity -- N-type for this standard NMOS technology.


Disclosure of Invention

The invention relates to an improved parallel plate capacitor in which a lower plate is a doped region of a semiconductor substrate and the upper plate has the opposite polarity dopant from that of the lower plate. The capacitor is employed in a circuit in which the relative polarity of the plates remains constant. The positive plate an N-type dopant and the negative plate has a P-type dopant.


Brief Description of Drawings

Figure 1 illustrates a prior art capacitor.

Figure 2 illustrates a capacitor according to the invention.

B-4026

Figure 3 illustrates a capacitor according to the invention in which there is a short circuit through the insulator.

Best Mode of Carrying Out the Invention

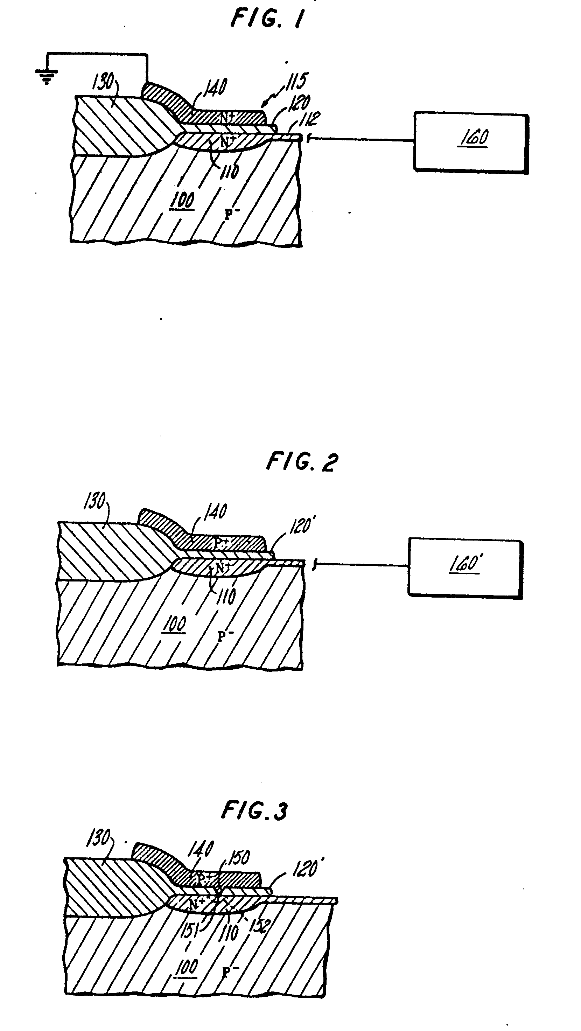

Referring now to figure 1, there is shown in cross section a parallel plate capacitor 115 constructed according to the prior art. Such capacitors are used by Mostek Corporation of Carrollton, Texas in their dynamic random access memories and are the disclosed in U.S. Patent 4,392,210. In this capacitor, P-type substrate 100 has an area within it that is doped N-type ($N^+$), indicated by the numeral 110 and a thinner connecting doped region indicated by the numeral 112. Region 110 is the lower plate of the capacitor and region 112 is an electrical connection between the doped plate region 110 and the rest of the circuit. Dopants are also referred to as conductivity-determining impurities and the terms are used interchangeably. Region 110 may be formed by any conventional means, such as by ion implantation. Above region 110, there is a thin oxide layer denoted by the numeral 120 and connected to it is a thick oxide layer denoted by the numeral 130. Above layer 120, top plate 140 is a layer of polycrystalline silicon doped $N^+$ and having the same polarity as region 110. In this prior art capacitor, region 140 is grounded and serves as the ground plate of the capacitor, while region 110 may be charged to a conventional voltage, illustratively +5 volts. To the right of capacitor 115 is a box 160 which is a conventional representation of the remainder of the circuit, in particular including means for charging plate 110 to the correct positive voltage. For example, box 160 may represent the remainder of a dynamic random access memory including all the input/output circuits, the remainder of the memory array and the access transistor to which capacitor 115 is connected. Top plate 140 may extend over several regions 110, since it is connected to ground.

Referring now to figure 2, there is shown a capacitor constructed according to the invention in which similar elements are indicated by the same numeral. Lower plate 110 and upper plate 140 are superimposed as before, with a thinner oxide 120' serving to separate the two plates. As is well known, when oxides become thinner, the number of pinhole openings in the oxide increases rapidly. In particular, in the range of approximately 100 angstroms, the number of pinholes per unit area increases exponentially as the thickness decreases. If there is a pinhole, then it is quite likely that the material of upper plate 140 will penetrate the pinhole, forming a short circuit between the two plates 110 and 140 of the capacitor and ruining a capacitor constructed according to the prior art. This capacitor, according to the invention, differs from the prior art capacitor not only in the thickness of the oxide, but also in the polarity of the dopant material. According to this invention, the material of plate 110 is still N-type but the material of plate 140 is doped differently, with a P-type material. Suitable materials for doping are well known to those skilled in the art. It is known in the art that Boron diffuses rather readily through thin oxide and there is some danger that enough Boron will diffuse through to plate 110 to degrade the performance of the circuit.

An important advantage of the present invention is illustrated in figure 3, in which pinhole 150 forms an opening between plate 140 and region 110 culminating in a point 151 at the top surface of region 110. A dotted line 152 indicates a region into which the P-type dopant, illustratively boron, has penetrated during the process of forming plate 140. When plate 110 is at ground and plate 140 is at ground, the short circuit makes no difference. When plate 110 is raised to a conventional magnitude of +5 volts, the combination of plate 110 and P-doped region 152 forms a reverse-biased P-N diode that forms a small depletion region about region 152 and passes no current. It is not necessary that the pinhole go all the way through the oxide. A partial penetration may allow a short circuit to form by breakdown of a thin remaining layer of oxide. Thus, in a capacitor constructed according to the invention, the effective area of the capacitor is reduced by the amount of the depletion region about P-doped region 152, but the capacitor is not short circuited when it is charged. This effect is referred to as "self-healing", since the capacitor heals short circuits. In the capacitor constructed according to the prior art, of course, pinhole 150 would form a short circuit and the current would flow between the plates 110 and 140, ruining the capacitor.

Those skilled in the art will be able to follow the principles of this invention to construct capacitors which are made sufficiently oversized to allow for the presence of one or more pinhole shorts and still have sufficient capacity resulting from the area outside the depletion region near the pinhole shorts to function correctly in a circuit. The magnitude of the area margin will depend, of course, on the usual engineering tradeoffs and, in particular, on the amplifiers connected to the capacitor for detecting the voltage state of the capacitor. In an illustrative example, the capacitor had an effective area of 16 sq. micron and a nominal thickness of oxide 120' of 100 angstroms resulting in an effective capacitance of 50 ff. When there was a single pinhole short in the capacitor, the effective capacitance was reduced to 37.5 ff, which was sufficient for the operation of the remainder of the circuit.

The voltage on plate 110 need not be +5 volts, of course, but there is a limitation on voltage connected with this invention. Because the self-healing process depends on the polarity of the capacitor plates, it is not possible to use a scheme such as the Vcc/2 arrangement in which one plate would be referenced at Vcc/2 and the other plate would be either Vcc or ground.

The circuit remainder 160 must be constructed to define a polarity for plates 110 and 140, by which is meant that either both plates will be at the same polarity or one will be positive with respect to the other. The identity of the more-positive plate cannot change. The figures show an embodiment of the invention in which one plate is in the substrate and the other is deposited polysilicon, but the invention is not restricted to this embodiment. Both plates could be deposited polysilicon, for example. If, however, plate 110 were made of P-type and plate 140 were N-type, (with an N-channel transistor) the capacitor would not be self-healing when plate 140 is at +5 volts. In that case, a corresponding region 152' would be N-doped in the P-type plate 110. The elective held from plate 140 would convert a top layer of plate 110, which is necessary to form a conductive path with region 112. In this case, there would be a short circuit through the pinhole to the inverted layer in plate 110 and the capacitor would be shorted.

Those skilled in the art will be able to apply this invention to other embodiments, such as an embodiment in which one plate is maintained at +5 volts and the other switches between +5 volts and ground. The use of an N-type substrate with corresponding charge in dopant and voltage will also be evident to those skilled in the art.

## Claims

1. An integrated circuit including at least one capacitor and comprising:

a first capacitor plate formed by the insertion of a predetermined quantity of a first conductivity-determining impurity in a predetermined area of a semiconductor material;

an insulator having a predetermined thickness and being disposed over said fist capacitor plate;

a second capacitor plate disposed over a portion of said first capacitor plate and separated from said first capacitor plate by said predetermined thickness of said insulator and comprised of a semiconductor material having a predetermined concentration of a predetermined conductivity-determining impurity, thereby forming a first one of said at least one integrated circuit capacitors; and

electrical means for applying a voltage across said first capacitor to define a polarity for each of said first and second capacitor plates; characterized in that:

said predetermined conductivity-determining impurity is a second impurity having a polarity opposite to that of said first conductivity determining impurity; and

that one of said first and seond capacitor plates having a positive voltage relative to the other one of said first and second capacitor plates has an N-type conductivity-determining impurity and the other one of said first and second capacitor plates has a P-type conductivity-determining impurity.

2. An integrated circuit according to claim 1, further characterized in that said first capacitor plate is formed in a predetermined area of a semiconductor substrate.

3. An integrated circuit according to claim 2, further characterized in that said second capacitor plate is connected to ground and has a P-type conductivity-determining impurity; said first capacitor plate has an N-type conductivity-determining impurity; and said semiconductor substrate has a P-type conductivity-determining impurity.

4. An integrated circuit according to claim 3, further characterized in that said electrical means includes means defining a dynamic random access memory having said at least one capacitor in the memory array thereof, with at least two of said capacitors sharing a common second plate extending continuously from a first determined area in said substrate to a second predetermined area in said substrate.

### FIG. 1

### FIG. 2

### FIG.3